# EUROPÄISCHE PATENTANMELDUNG

(11) **EP 0 757 448 A2**
(43) Veröffentlichungstag der Anmeldung: **05.02.1997**
(21) Anmeldenummer: 96112499.7
(22) Anmeldetag: 02.08.1996
(51) Int. Cl.: H03M 13/00, H03M 13/22, H04L 1/00

(54) **Verfahren zur Übertragung von diskreten Nachrichtensignalen**

(30) Priorität: 04.08.1995 DE 19528795
(71) Anmelder: Daimler-Benz Aerospace Aktiengesellschaft, 81663 München (DE)
(72) Erfinder: Wörrlein, Hans Hermann, Dr.-Ing., 85622 Feldkirchen (DE)

(57) **Zusammenfassung**

Es wird ein Verfahren zur Übertragung von diskreten Nachrichtensignalen vorgeschlagen, bei dem die verschiedenen Signale, die senderseitig zur Auswahl bereitgehalten werden, derart strukuriert werden, daß sie sich maximal voneinander unterscheiden, indem die Festlegung des Kodes so getroffen wird, daß die sogenannte Hamming-Distanz beliebiger Kodewörter, d.h. die Anzahl der Bits, in denen sie sich unterscheiden, stets maximal wird, gleichgültig welches Paar von Kodewörtern ausgewählt wird.

Ferner wird eine Anleitung zur Synthese derartig optimaler Kodes gegeben.

## Beschreibung

Die Erfindung betrifft ein Verfahren zur Übertragung von diskreten Nachrichtensignalen, beispielsweise von Kommandosignalen in einem Lenkwaffensystem zur Flugabwehr.

In einem derartigen System besteht der Bedarf, die Kommandosignale zur Steuerung des Flugkörpers (FK) von einem Sender, der sich normalerweise am Ort der Lenkeinrichtung am Boden befindet, zum Flugkörper in der Luft zu übertragen. Die Kommandos können Signale zur Steuerung der Rudermaschinen, Befehle an den Autopiloten oder zur Steuerung des Zielsuchkopfes (ZSK), des Zünders oder des Gefechtskopfes und anderer Komponenten mehr beinhalten.

In manchen Systemen ist es auch erforderlich, entsprechende Signale vom FK zur Abschußanlage zurückzusenden. Ferner besteht die Möglichkeit, daß kodierte Signale von der Bodenanlage, d.h. von einem Radarsender oder einem Beleuchter zum Ziel gerichtet werden, am Ziel reflektiert werden und dann zum Flugkörper gelangen. Derartige indirekte Verbindungen spielen insbesondere dann eine Rolle, wenn die Sichtlinie zum Flugkörper zeitweilig unterbrochen ist, ferner bei bestimmten ECM-Situationen, sowie bei der Track-Via-Missile- oder TVM-Technik, die beim Boden-Luft-Lenkwaffensystem Patriot als eine von mehreren Techniken vorgesehen ist.

Im betrachteten Fall besteht der Nachrichteninhalt in der binären Kodierung, welche dem Signal üblicherweise in Form einer Phasenumtastung oder auch durch 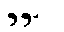 Frequency Shift Keying" (FSK) aufgeprägt wird.

Unter idealen Bedingungen, d.h. wenn das Systemrauschen sehr gering ist und wenn keine gewollten oder ungewollten Störungen des Systems erfolgen, erhält der Nachrichtenempfänger nach Demodulation des empfangenen Signals eine Kopie der gesendeten Nachricht.

Bei realen Systemen, insbesondere bei militärischen Systemen, kann man nie von derart idealen Voraussetzungen ausgehen. Man muß vielmehr annehmen, daß die Übertragung entweder mit Absicht seitens eines Gegners oder unabsichtlich, beispielsweise durch benachbarte oder andere Systeme gestört wird.

Unter dieser Randbedingung der berücksichtigten, d.h. im Konzept bereits einkalkulierten Störung besteht die Aufgabe, die Kodierung der Nachrichtensignale derart zu bestimmen, daß die Übertragung möglichst wenig störanfällig ist.

Erfindungsgemäß erreicht man das damit, daß sich die verschiedenen Signale, die senderseitig zur Auswahl stehen, maximal voneinander unterscheiden.

Wenn man eine vorherbestimmte Auswahl von Zeichen zur Verfügung hat, beispielsweise die Symbole eines 8-Bit-ASCII-Kodes, so erreicht man die Störsicherheit dadurch, daß man pro Symbol nicht nur die unbedingt erforderlichen Bits überträgt, im Fall dieses Beispiels also 8 Bits, sondern zusätzliche Bits zur Erzielung einer Redundanz.

In der Vergangenheit wurden diese Zusatzbits beispielsweise zur Übertragung von Checksummen herangezogen, welche innerhalb von gewissen Grenzen Fehler bei der Übertragung erkennen lassen oder sogar korrigieren lassen.

Beim erfindungsgemäßen Verfahren wird die Festlegung des Kodes so getroffen, daß die sogenannte Hamming-Distanz beliebiger Kodewörter, d.h. die Anzahl der Bits, in denen sie sich unterscheiden, stets maximal wird, gleichgültig welches Paar von Kodewörtern man herausgreift.

Einzelheiten der Erfindung ergeben sich aus den Unteransprüchen und der Beschreibung, in der sowohl die der Erfindung zugrundeliegenden Überlegungen als auch Ausführungsbeispiele zur Realisierung beschrieben sind. Dabei zeigen
- Fig. 1: schematisch die Nachrichtenübertragung zwischen Bodenstation und Flugkörper,
- Fig. 2: schematisch die Permutation des Signals,
- Fig. 3: schematisch den Nachrichtensender und
- Fig. 4: schematisch den Nachrichtenempfänger.

Zunächst wird ein Verfahren beschrieben, nach dem es möglich ist, die einzelnen Elemente des derart optimalen Kodes festzulegen, d.h. es wird eine Anleitung zur Synthese des Kodes gegeben.

Will man diskrete Nachrichten möglichst effizient übertragen, so kann man jeder Nachricht ein binäres Kodewort zuordnen. Diese Art der Kodierung wird vorzugsweise mit Blockkodes bewirkt und hierin wiederum sind die Gruppenkodes von großer Bedeutung.

Die einzelnen Kodewörter sind nichts weiter als die Elemente einer Gruppe, genauer gesagt: einer Abelschen Gruppe, d.h. der Kode besteht aus einer Anzahl von linear unabhängigen Basisvektoren und aus sämtlichen Linearkombinationen dieser genannten Basisvektoren.

Die Summe zweier Kodewörter, Bit für Bit nach den Regeln der Modulo-2 Addition gebildet, ist dann wieder ein Kodewort. Das Summenwort hat an den Bitpositionen eine Eins, wo sich die Summanden unterscheiden. Daher ist die Anzahl der Einsen im Summenwort gleich der Hamming-Distanz der Ausgangswörter.

Man muß daher verlangen, daß kein Kodewort weniger Einsen enthält, als durch eine Grenze vorgegeben ist und daß diese Grenze so hoch wie möglich angesetzt wird.

Ist der Kode erst bekannt, so ist es verhältnismäßig einfach, seine postulierte Optimalität zu verifizieren.

Das Bildungsgesetz des Kodes ist wie folgt:

Wenn die Hamming-Distanz den Wert n haben soll, so werden die Basisvektoren nach dem folgenden Gesetz gebildet:

Der erste Basisvektor, b1, enthält Einsen an den n1 = n niedrigsten Stellen, ansonsten nur Nullen.

Der zweite Basisvektor b2, wird gewonnen, indem die n2 = n1 / 2 Stellen, wenn n1 eine gerade Zahl ist, ansonsten die n2 = (n1 + 1 ) / 2 Stellen vor der führenden Eins von b1 mit Einsen aufgefüllt werden, zur Rechten gefolgt von einem ebensolangen Block von Nullen und dem Rest dann wieder Einsen.

Der dritte Basisvektor b3 zieht n3 = n2 / 2 Einsen oder n3 = (n2 + 1) / 2 Einsen, je nachdem, ob n2 gerade oder ungerade ist, vor die führende Eins von b2, nach rechts gefolgt von einem alternierenden Muster von jeweils n3 Nullen und Einsen.

Diese Regel wird fortgesetzt, bis bei der fortlaufenden Halbierung der vorgezogenen Einserstellen nur noch eine einzige Eins verbleibt. Mit dieser Eins in der ersten Stelle wird der letzte der Basisvektoren gebildet.

Diese Regel, die gedanklich die Grundlage der Erfindung liefert, soll an einem Beispiel erläutert werden. Es soll gefordert sein, einen optimalen Gruppenkode der Länge 31 mit einer Hammingdistanz von 16 zu bilden.

Die Basisvektoren dieses Kodes sind dann:

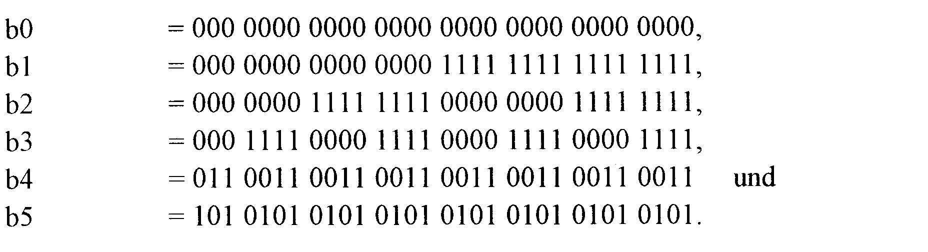

Der vollständige Kode ergibt sich als Gesamtheit der Linearkombinationen der Basisvektoren:

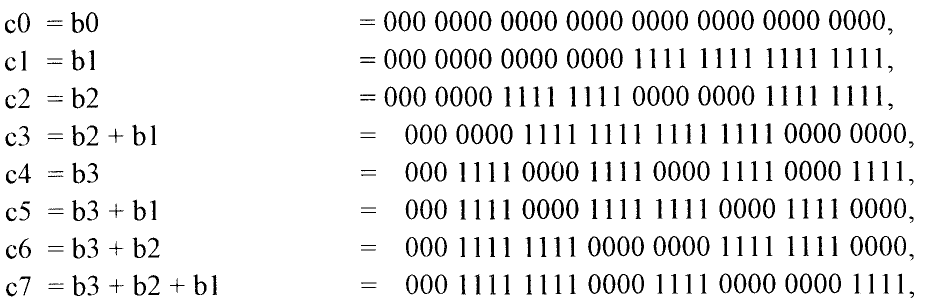

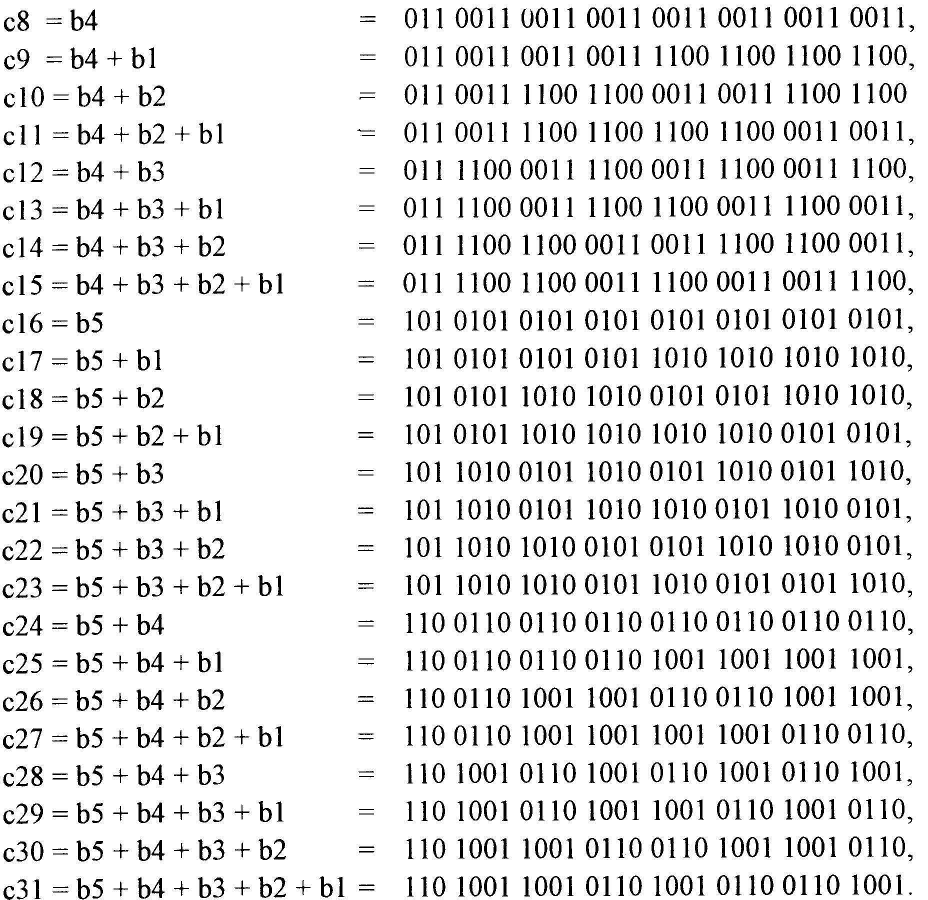

Wie man leicht sieht, besitzen alle Codewörter, mit Ausnahme des"Einheits"-Elements c0 der Gruppe, 16 Einsen. Da der Abstand zweier Elemente gleich der Anzahl der Einsen ist, welche das Wort enthält, das durch Exklusiv-Oder-Verbindung der beiden genannten Elemente gebildet wird und da jede derartige Exklusiv-Oder-Verbindung in dem obigen Schema auftritt, ist somit erwiesen, daß in diesem Kode alle Elemente die Hamming-Distanz 16 zueinander besitzen.

Es wurde durch zahlreiche Überprüfungen bestätigt, daß ein derartig aufgebauter Kode bei der Kodelänge 2ⁿ oder 2ⁿ - 1 stets die gewünschte Optimalität besitzt.

Bei abweichender Kodelänge wird häufig die Optimalität erreicht oder der Kode weicht in seinen Eigenschaften nur geringfügig vom theoretischen Optimum ab.

Von besonderem praktischen Interesse sind die Kodes der Länge 2ⁿ - 1, auch deshalb, weil für diese Kodelänge die sogenannten linearen Schieberegistersequenzen maximaler Länge bekannt und leicht zu generieren sind.

Der erfindungsgemäß verwendete Kode hat zwei bemerkenswerte Eigenschaften:
1. Die Optimalität wird nicht gestört, wenn man zu sämtlichen Kodewörtern eine beliebige gleichbleibende Bitsequenz nach den Regeln der Modulo-2-Addition addiert oder wenn eine bitweise Exklusiv-Oder-Verknüpfung durchgeführt wird und:
2. Die Optimalität wird ebenfalls nicht gestört, wenn man die Spalten des Kodes, d.h. die Spalten, in denen die Bits stehen, beliebig umordnet oder permutiert.

Selbstverständlich können diese beiden Regeln auch im Verbund zur Verwendung kommen.

Von besonderem praktischen Anreiz ist es, nach der Regel 1 zu verfahren und eine lineare Schieberegistersequenz mit dergleichen Länge wie die Kodelänge zu addieren. Aus dem Kodewort, das ursprünglich aus lauter Nullen besteht, wird dann der Kode des Schieberegisters. Dieser Kode zeichnet sich bekanntlich durch eine Autokorrelationsfunktion mit hervorstechenden Eigenschaften aus, welche zur Synchronisierung des Empfängers besonders gut geeignet ist.

Man kann auch andere Sequenzen, beispielsweise einen Barkerkode oder eine Verschachtelung eines Barkerkodes mit einer Pseudozufallssequenz oder mit einer echten Zufallssequenz oder eine Zufallssequenz für sich allein zur Synchronisierung verwenden. In jedem Fall behält der resultierende Kode das Merkmal, daß sich die Kodewörter maximal voneinander unterscheiden und daher minimal gegen Störungen anfällig sind.

Um das oben begonnene, einfache Beispiel fortzuführen, wird eine lineare Schieberegistersequenz der Länge 31 niedergeschrieben:

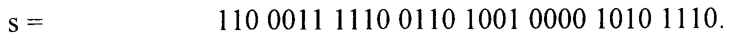

Der erfindungsgemäße Kode ist in diesem Fall gegeben durch:

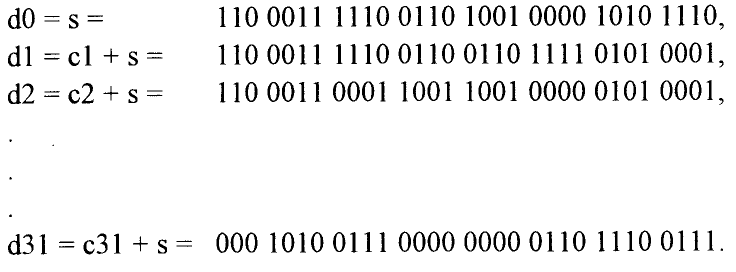

Die zweite oben genannte Regel, die Permutierung der Spalten des Kodes, wird zweckmäßigerweise auch zur Erhöhung der Störsicherheit herangezogen.

Bildet man einen Kode nach der oben genannten Gesetzmäßigkeit, so weist dieser sehr systematische Eigenschaften auf und es wäre zumindest in Kenntnis der vorgenannten Regeln relativ leicht, den Kode nachzuempfinden. Durch die Permutation der Spalten wird so viel zusätzliche Willkürlichkeit ermöglicht, daß ein Nachempfinden des Kodes praktisch unmöglich wird.

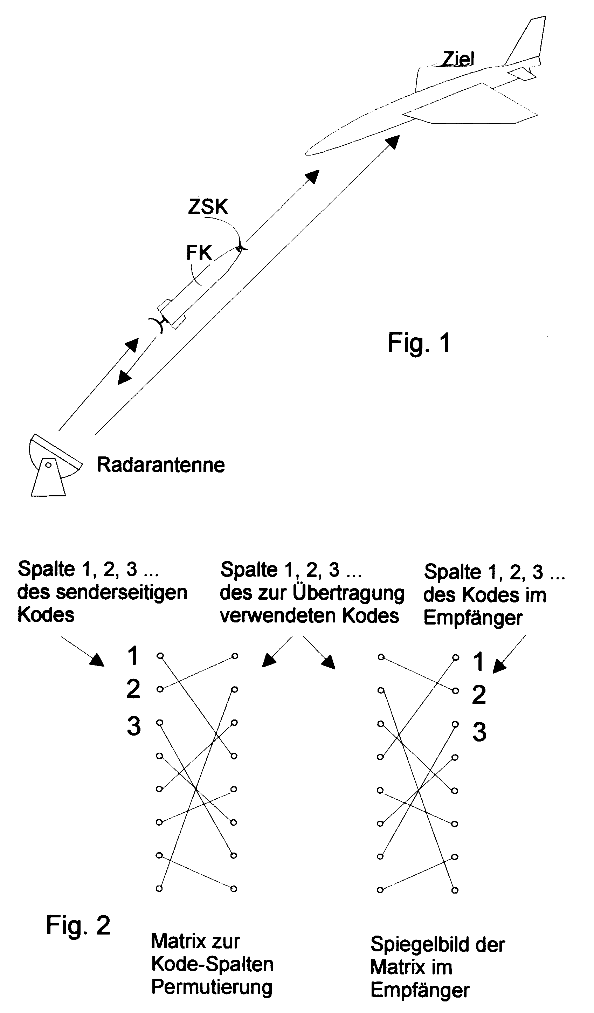

Eine weitere, bevorzugte Implementierung des Erfindungsgedankens ist es daher, den Kode wie beschrieben zu erzeugen, eine Schieberegistersequenz zur Synchronisierung zu addieren und anschließend die Spalten des Kodes zu permutieren. Auf diese Weise wird verhindert, daß in dem gesendeten Signal eine an sich bekannte Schieberegistersequenz erscheint. Diese Anwendung wird durch das Schema der Fig. 2 veranschaulicht.

Eine weitere Anwendung ist es, diesen Gedanken fortzuführen, indem der Schlüssel zur Permutierung in regel- oder unregelmäßigen Zeitabständen verändert wird. Bezogen auf die Ausdrucksweise der Fig. 2 hieße dies, die Verbindungen in den als Matrix bezeichneten Elementen variabel zu gestalten.

Eine spezielle Anwendung ist es, den Schlüssel zur Permutierung durch den Empfänger bestimmen zu lassen. Hierbei ist speziell an militärische Anwendungen zu denken. Ein Flugkörper, welcher vor seinem Abschuß mit der Abschußanlage durch eine Nabelschnur verbunden ist und dem ein individueller Permutierungsschlüssel bei seiner Fertigung vorzugsweise in einem ROM oder als Bestandteil eines ohnehin vorhandenen ROMs mitgegeben worden ist, teilt der Abschußanlage vor dem Schuß über die genannte Nabelschnur mit, für welche Permutierung er eingerichtet ist. Auf diese Weise wechselt die Permutierung in zufälliger Weise von einem Schuß zum nächsten. Auch wenn die zugrundegelegten Prinzipien bekannt sind, kann der Gegner daraus keinen speziellen Vorteil ziehen, da er die Permutierung nie vorherbestimmen kann.

Eine weitere Spielart ist es, dem Flugkörper bei seiner Fertigung den gesamten Kode mitzugeben, den er vor dem Abschuß an die Waffenanlage mit Hilfe der zitierten Nabelschnur überträgt. In dieser Variante erhält die Bodenanlage erst durch die Verbindung mit dem startbereiten Flugkörper Kenntnis von der Kodierung.

Eine weitere Variante des Erfindungsgedankens ist es, die Nabelschnur durch eine drahtlose Verbindung zu ersetzen.

Eine weitere Variante des Erfindungsgedankens ist es, daß ein Flugkörper nur einen Teil eines Kodes, beispielsweise nur 128 von möglichen 256 Kodewörtern verwendet. Die verbleibenden, für diesen FK nicht genutzten 128 Kodewörter können dann zur simultanen Steuerung eines zweiten FK's verwendet werden.

Die genannten Signale zur Synchronisation können entweder alternierend mit den Steuersignalen oder mit vereinbarten Blocks von Steuersignalen generiert werden oder auf ihre getrennte Übertragung kann verzichtet werden, d.h. jedes gesendete Kodewort beinhaltet sowohl die Synchronisations- als auch die zu übertragende Nutzinformation.

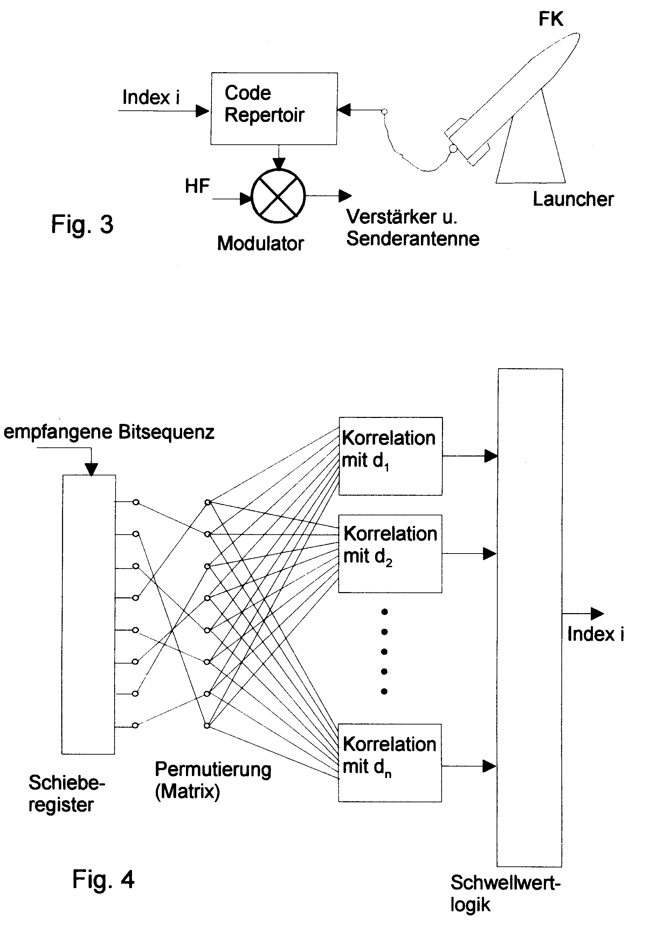

In der Fig. 3 ist ein Nachrichtensender dargestellt, welcher die Erfindung implementiert, gefolgt in der Fig. 4 von einem Schema des Empfängers.

Die Nachricht besteht darin, das i-te Signal aus einem Katalog von n Signalen zur Übertragung zu bringen. Der Sender wählt das i-te Kodesignal aus seinem Repertoir von Kodesignalen aus, wobei dieses Repertoir entweder fix eingeprägt sein kann oder vorzugsweise vor dem Abschuß über die Nabelschnur eingelesen wird. Die oben genannte Permutierung ist dadurch verwirklicht, daß dem Flugkörper bei seiner Fertigung ein permutierter Kode eingeprägt worden ist.

Diesem Kode ist eine Schieberegistersequenz überlagert, wie oben dargestellt. Die Schieberegistersequenz ist ebenfalls Bestandteil des genannten Kodes, der über die Nabelschnur bezogen wird.

Das dergestalt permutierte und von der Schieberegistersequenz überlagerte Signal wird einem HF-Signal in an sich bekannter Weise als Modulation aufgeprägt. Das Modulationsverfahren verwendet üblicherweise eine Phasenumtastung einer Trägerfrequenz. Die Erfindung ist jedoch nicht auf diese spezifische Art der Modulation beschränkt. Die Erfindung kann gleichermaßen im Verbund jeder anderen Modulationstechnik verwendet werden.

Wenngleich der Sender für den Fall des i-ten Signals beschrieben worden ist, so ist doch zu verstehen, daß normalerweise die Aufgabe nicht damit erledigt ist, daß eine einzige Information übertragen wird, sondern daß nach der gleichen Methode eine zeitliche Sequenz von meist veränderlichen Signalen gesendet wird.

Im Empfänger, Fig. 4, wird nach den üblichen Schritten der Verstärkung und Demodulation des empfangenen Signals zunächst die Permutierung rückgängig gemacht, d.h. die zeitliche Sequenz der empfangenen Bits wird durch die spiegelbildliche Matrix des Empfängers, vgl. Fig. 2 und Fig. 4, neu geordnet. Erst nach dieser Umgruppierung der Bits wird eines der Kodeworte d₀ bis d₃₂ oder dₙ zu sehen sein. Es besteht aber noch immer, sofernnicht nur ein einziges, diskretes Nachrichtensignal, sondern eine kontinuierliche Folge gesendet wird, das Problem, daß der Anfang und das Ende des Kodeworts im Empfänger zunächst nicht bekannt ist.

Erfindungsgemäß wird dieses Problem der Synchronisierung dadurch gelöst, daß man die empfangene Sequenz permanent mit sämtlichen Kodewörtern des Alphabets vergleicht. Dieser Vergleich wird üblicherweise mit einem Korrelator bewerkstelligt, d.h. es werden ebensoviele Korrelatoren wie Kodewörter implementiert.

In dem Augenblick, in welchem die zeitliche Verschiebung der empfangenen Sequenz und der Referenzsignale der Korrelatoren genau "paßt", d.h. wenn ihre Verschiebung einen Nulldurchgang hat, erscheint am Ausgang eines der Korrelatoren ein scharfes Maximum, und die Kanalnummer dieses Korrelators gibt den Index des gesendeten, i-ten Signals an, d.h. beinhaltet die zu entschlüsselnde Nachricht.

Es ist für den Fachmann selbstverständlich, daß die Funktion des beschriebenen Empfängers sinngemäß auch in abweichender Form realisiert werden kann. Beispielsweise können die zahlreichen parallelen Korrelatoren durch einen einzigen, schnelleren Korrelator ersetzt werden, welcher dann die geschilderten Schritte in einem schnellen Zeitmultiplex ausführt. Oder es ist, im Extremfall, auch daran zu denken, die Gesamtheit der logischen Schritte in der Software des Bordrechners, des sogenannten Autopiloten unterzubringen.

## Patentansprüche

1. Verfahren zur Übertragung von diskreten Nachrichtensignalen, **dadurch gekennzeichnet,** daß die verschiedenen Signale, die sonderseitig zur Auswahl bereitgehalten werden, derart strukturiert werden, daß sie sich maximal voneinander unterscheiden, indem die Festlegung des Kodes so getroffen wird, daß die sogenannte Hamming-Distanz beliebiger Kodewörter, d.h. die Anzahl der Bits, in denen sie sich unterscheiden, stets maximal wird, gleichgültig welches Paar von Kodewörtern ausgewählt wird.

2. Verfahren nach Anspruch 1, **dadurch gekennzeichnet,** daß zu sämtlichen Kodewörtern eine beliebige gleichbleibende Bitsequenz nach den Regeln der Modulo-2-Addition addiert oder eine bitweise ExklusivOder-Verknüpfung durchgeführt wird.

3. Verfahren nach Anspruch 1 oder 2, **dadurch gekennzeichnet,** daß die Spalten des Kodes, d.h. die Spalten, in denen die Bits stehen, umgeordnet oder permutiert werden.

4. Verfahren nach Anspruch 3, **dadurch gekennzeichnet,** daß die Permutation nach einem Schlüssel erfolgt, der vom Empfänger der Nachricht bestimmt und vor Aufbau der Verbindung dem Sender mitgeteilt wird.

5. Verfahren nach Anspruch 3, **dadurch gekennzeichnet,** daß die Permutation nach einem Schlüssel erfolgt, der vom Sender der Nachricht bestimmt und vor Aufbau der Verbindung dem Empfänger mitgeteilt wird.

6. Verfahren nach einem der vorhergehenden Ansprüche, **dadurch gekennzeichnet,** daß das s permutierte Signal mit einer Schieberegistersequenz überlagert und einem HF-Signal als Modulation aufgeprägt wird, daß im Empfänger die Permutierung rückgängig gemacht und zum Bestimmen von Anfang und Ende des Kodeworts die empfangene Sequenz permanent mit sämtlichen möglichen Kodewörtern mit Hilfe eines Korrelators verglichen wird.

7. Verfahren nach Anspruch 6, **dadurch gekennzeichnet,** daß die Zahl der Korrelatoren im Empfänger der Zahl der möglichen Kodewörter entspricht, daß das empfangene Signal von den Korrelatoren parallel verarbeitet wird und daß bei Vorliegen von Korrelation in einem Korrelator dessen Kanalnummer die zu empfangende Nachricht ergibt.

8. Verfahren nach Anspruch 6, **dadurch gekennzeichnet,** ein schneller Korrelator das empfangene Signal im Zeitmultiplexverfahren verarbeitet.
